# EUROPÄISCHE PATENTSCHRIFT

(11) **EP 0 517 690 B1**
(45) Veröffentlichungstag und Bekanntmachung des Hinweises auf die Patenterteilung: **06.08.1997**
(21) Anmeldenummer: 92890126.3
(22) Anmeldetag: 26.05.1992
(51) Int. Cl.: H03M 1/22, G01D 5/245

(54) **Inkrementales Messsystem**
Incremental measuring system
Système de mesure incrémentale

(30) Priorität: 03.06.1991 AT 1112/91
(43) Veröffentlichungstag der Anmeldung: 09.12.1992
(73) Patentinhaber: RSF-Elektronik Gesellschaft m.b.H., A-5121 Tarsdorf 93 (AT)
(72) Erfinder: Rieder, Heinz, A-5110 Oberndorf (AT); Schwaiger, Max, A-5121 Ostermiething (AT)
(74) Vertreter: Hübscher, Heiner, Dipl.-Ing.

(56) Entgegenhaltungen:
- EP-A- 0 292 151
- GB-A- 2 100 423
- US-A- 3 496 374
- US-A- 4 987 414

## Beschreibung

Die Erfindung betrifft ein inkrementales Meßsystem mit einem eine Meßteilung tragenden Maßstab und in wenigstens einer eigenen Abtastspur angeordneten Referenzmarken, wobei
- für die Meßteilung und die Referenzmarkenspur gesonderte Abtasteinheiten zur Erzeugung von Meßsignalen und von der Abtastung der Meßteilung unabhängigen Referenzsignalen vorgesehen sind,
- phasenverschobene periodische Hilfssignale erzeugt werden, für die Erzeugungsschaltungen zur Erzeugung von dem Teilungsgrad der Meßteilung entsprechenden digitalen Ausgangssignalen vorgesehen sind, wobei diese Ausgangssignale bei an der entsprechenden Abtasteinheit bei ihrer Ausrichtung auf eine Referenzmarke anstehendem Referenzsignal in einer vorwählbaren Phasenlage der Hilfssignale zur Auflösung und zur Begrenzung der Impulsbreite eines weitergeleiteten Referenzimpulses verwendet werden
- und das aus Meßteilung und zugeordneten Abtasteinheiten gebildete Meßsystem ein hohes Auflösungsvermögen aufweist.

Aus der GB 2 100 423 A ist ein inkrementales Meßsystem bei einem Drehgeber bekannt, bei dem der Hauptmaßstab aus einer Inkrementalteilung besteht, die über Abtasteinheiten zur Erzeugung phasenverschobene Analogsignale abgetastet wird, wobei die Meßteilung des Hauptmaßstabes durch Potentiometer- bzw. Phasenschieberschaltungen elektronisch in eine Vielzahl von Signalzügen unterteilt wird, aus denen dann im Sinne der elektronischen Unterteilung des Haußtmaßstabes Zählsignale abgeleitet werden, die der Messung zugrundeliegen. Zur Bestimmung der Referenzstelle dient eine hier äußerst einfach aufgebautet Referenzmarke, deren Aufgabe darin besteht, nur jenen Bereich des Hauptmaßstabes anzugeben, aus dem in weiterer Folge ein Referenzsignal abgeleitet werden soll. Die meist über ein vollständiges Inkrement des Hauptmaßstabes reichende Referenzmarke wird abgetastet und das aus ihr gewonnene Signal wird in ein Rechtecksignal umgewandelt, das einem Diskrimintator zugeführt wird. Ferner wird im Diskriminator vorgegeben, aus welchem der am Hauptmaßstab erzeugten und unterteilten Signalzüge das eigentliche Referenzsignal abgeleitet werden soll. Tritt dieser Fall ein, so wird an einer dem Hauptmaßstab genau zugeordneten Stelle ein Referenzsignal erzeugt, dessen Signalbreite der Signalbreite eines aus der Unterteilung gewonnenen Zählsignales entspricht. Die Erzeugung des Referenzsignales ist also hier immer von der Abtastung des Hauptmaßstabes abhängig, nur bei einer bestimmten Maßstabform verwirklichbar und überdies insofern problematisch, als mit der einfachen Referenzmarke keine Signalform erzeugt werden kann, deren Anfang und Ende exakt mit Teilungsbeginn bzw. Teilungsende eines Maßstabinkrementes zusammenfällt. Man kann daher innerhalb des erzeugten, als Bereitstellungssignal dienenden Signales nur einen kleinen Bereich tatsächlich für die Bereitstellung der Auslösung des Referenzsignales heranziehen.

Bei Meßsystemen mit hohem Auflösungsvermögen ist es schhwierig bzw. manchmal sogar unmöglich, das Referenzsignal mit so geringer Signalbreite zu erzeugen, daß diese gleich oder kleiner als eine Teilungsstufe der Inkrementalteilung oder sonstigen Meßteilung am Maßstab wird. Eine genaue Zuordnung des Referenzsignales zu einer bestimmten Stelle der Meßteilung ist aber notwendig, um die Lage des Referenzpunktes eindeutig zu definieren. Für eine exakte Bestimmung des Referenzpunktes selbst ist es aus der EP 0 292 171 bekannt, im Bereich des Referenzpunktes zwei gegengleich ausgeführte Referenzmarken neben- oder übereinander anzuordnen, so daß in den entsprechenden Abtasteinheiten beim Überfahren gegengleiche Signale entstehen. Durch Zusammenfügung der beiden Signale erreicht man bei entsprechendem Muster der Marken bzw. Abtasteinheiten, daß zwischen den beiden an den einzelnen Abtasteinheiten auftretenden Signalspitzen sich bei Invertierung des einen Signales ein im wesentlichen geradliniger Signalverlauf mit im wesentlichen ausgeprägtem Nulldurchgang ergibt. Durch Komperatoren mit positivem und negativem Ansprechpegel kann man aus dem so erzeugten Analogsignal ein Referenzsignal ableiten, dessen Breite durch die Einstellung der Komperatoren verändert werden kann, aber vorzugsweise immer symmetrisch zum Nulldurchgang des Summensignales verläuft. Es ist daher hier nicht möglich, das Signal auf eine vorwählbare Unterteilerstufe des Hauptmaßstabes auszurichten. Es ist nun beispielsweise schwierig, Meßsystemen bei denen Meßteilung und Abtastgitter der Abtasteinheit für den Hauptmaßstab als Phasengitter ausgebildet sind und bei der Abtastung der Meßteilung ein Auflösungsvermögen in Bruchteilen von µm erreicht wird, mit als Phasengitter ausgebildeten Referenzmarken und entsprechenden Abtasteinheiten auszustatten.

Die Aufgabe der Erfindung besteht darin, ein inkrementales Meßsystem mit hochauflösender, z.B. als Phasengitter ausgebildeten Meßteilung, der entsprechende Abtasteinheiten zugeordnet sind, zu schaffen, bei dem ein Referenzsignal in genauer Zuordnung zu einem bestimmten Punkt der Meßteilung und mit einer Signalbreite erzeugt werden kann, die vorzugsweise kleiner als der Teilungsschritt der Meßteilung ist.

Bei einem Meßsystem der eingangs genannten Art wird die gestellte Aufgabe dadurch gelöst, daß die Referenzmarkenspur zumindest im Bereich der Referenzmarken ein- oder beidseitig mit einer eine geringere Auflösung als die Meßteilung aufweisenden Inkrementalteilung, insbesondere einer ebenso wie die in diese Inkrementalteilung integrierten Referenzmarken nach optoelektronischen Abtastprinzipien abtastbaren Inkrementalteilung versehen ist, für die eigene Abtasteinheiten zur Erzeugung der phasenverschobenen periodischen Hilfssignale vorgesehen sind und daß die Erzeugungsschaltungen Unterteilerschaltungen sind, die die Hilfs-lnkrementalteilung elektronisch unterteilen.

Totzdem kann die Breite des Referenzsignales auf einen kleinen Bruchteil des aus der Abtastung der Referenzmarke gewonnenen Signales beschränkt und exakt einem ganz bestimmten Punkt der Meßteilung zugeordnet werden. Der physikalische Aufbau der Meßteilung kann von jenem der Hilfsteilung und der Referenzmarken abweichen, wobei diese Spur mit den zugeordneten Abtasteinheiten sogar nach anderen Abtastprinzipien wie die Meßteilung abgetastet werden kann. Auf das schon erwähnte Beispiel der Ausbildung der Meßteilung als über Phasengitter abtastbare Phasengitterteilung wird Bezug genommen. Schon eingangs wurden bekannte Unterteilerschaltungen zur Erhöhung des Auflösungsvermögens bei der Abtastung von Inkrementalteilungen erwähnt, die hier bei der Abtastung der Inkrementalteilung der Referenzmarkenspur ebenso wie andere bekannte Unterteilerschaltungen Verwendung finden können. Neben Potentiometerschaltungen sind auch integrierte Schaltbausteine, z.B. in Form von Rechnerbausteinen, bekannt, die entsprechende Unterteilungssignale erzeugen, und hier einsetzbar sind.

Eine Weiterbildung des Erfindungsgegenstandes sieht vor, daß die Abtasteinheiten für die den Referenzmarken zugeordnete Inkrementalteilung zur Erzeugung von zwei gegeneinander um 90° phasenverschobenen, sinusförmigen HiIfssignalen um Teilungsbruchteile versetzte Abtastgitter aufweisen und daß für die Auslösung des Referenzimpulses eine bei anstehendem Referenzsignal auf gleiche Signalhöhen der beiden Hilfssignale (Schnittpunkte der beiden Spannungskurven) empfindliche Triggerschaltung vorgesehen ist. Im Bedarfsfall kann die Auslösung des Referenzimpulses auch in anderen genau definierten Phasenlagen der Hilfssignale erfolgen, wobei, wie schon erwähnt wurde, die Impulsbreite des Referenzimpulses auf den Unterteilungsschritt der Hilfssignale durch die Unterteilerschaltungen begrenzt ist.

Um sonst theoretisch in manchen Fällen mögliche Fehler durch Verzerrungen der analogen Hilfssignale oder durch fehlerhaften Phasenversatz dieser Hilfssignale der sich z. B. leichter Schrägstellung der Abtastgitter ergeben kann, auszugleichen und eindeutige Bedingungen zu schaffen, ist nach einer Weiterbildung vorgesehen, daß den Abtasteinheiten für die Hilfssignale und das Referenzsignal eine Abgleichschaltung zur Normierung der Signalformen aller Signale und der Phasenabstände der Hilfssignale nachgeordnet ist.

Gemäß einer Weiterbildung des Erfindungsgegenstandes ist für die phasenverschobenen analogen Hilfssignale eine Frequenzverdoppelungsschaltung mit festen Rechnerbausteinen vorgesehen. Durch diese Ausführung wird es möglich, an vorhandenen Unterteilerschaltungen das Auflösungsvermögen zu verdoppeln und dementsprechend die halbe Impulsbreite des Referenzimpulses zu erzielen. In manchen Fällen genügt schon die Verwendung der Frequenzverdoppelungsschaltung überhaupt, um mit nachgeordneten, einfachen Auswertungsschaltungen zur Umwandlung der analogen Hilfssignale in digitale Signale das Auslangen zu finden. Grundsätzlich ist aber die Verwendung einer Frequenzverdoppelungsschaltung der genannten Art auch bei inkrementalen Meßsystemen an sich möglich, da mit entsprechenden Bausteinen bereits eine Verdoppelung des Auflösungsvermögens bei der Abtastung einer inkrementalen Meßteilung ermöglicht wird und die erhaltenen die doppelte Frequenz besitzenden analogen Ausgangssignale mit den üblichen Auswertungsschaltungen einfach in digitale Zählsignale verarbeitet werden können.

Nach einer vorteilhaften Ausführung weist die Frequenzverdoppelungsschaltung je einen Vierquadrantenmultiplizierer für das sin- und cos-Signal zur Bildung von sin²x und cos²x auf, deren Ausgänge mit einem Subtrahierer verbunden sind, an dessen Ausgang das Signal cos 2x ansteht und ein weiterer quadrantenmultiplizierer sowohl mit dem Signal sin x als auch dem cos x zur Bildung eines sin x * cos x = 0,5 sin 2x- Signales am Ausgang beaufschlagbar ist.

Nach einer Variante weist die Frequenzverdoppelungsschaltung je einen Vierquadrantenmultiplizierer für das sin- und cos-Signal zur Bildung von sin²x und cos²x auf, deren Ausgänge mit einem Subtrahierer verbunden sind, an dessen Ausgang das Signal cos 2x ansteht und zwei weitere Vierquadrantenmultiplizierer über π /4-Phasenschieber mit den Signalen cos (x + 45) bzw. sin (x + 45) beaufschlagbar sind und die an ihren Ausgängen auftretenden Signale cos² (x + 45) bzw. sin² (x + 45) in einem Subtrahierer zu dem Signal sin 2x verknüpft werden.

Schließlich ist auch eine Ausführung möglich, bei der die Frequenzverdoppelungsschaltung einen mit dem sin x und cos x-Signal beaufschlagten Vierquadrantenmultiplizierer zur Bildung von sin x * cos x = 0,5 * sin 2x und einen weiteren, über π/4 Phasenschieber mit den Signa-len cos (x + 45) und sin (x + 45) beaufschlagten Vierquadrantenmultiplizierer zur Bildung von sin (x + π/4) * cos (x + π/4) = 0,5 * cos 2x aufweist.

Jede der beschriebenen Varianten hat bestimmte charakteristische Eigenschaften hinsichtlich der Auswirkung von Phasenverschiebungen der Eingangssignale auf die Ausgangssignale, wobei nach der ersten und dritten Variante bei Phasenverschiebungen am Eingang Offsetschwankungen an einem Ausgangssignal auftreten und bei der zweiten Variante Phasenverschiebungen am Eingang zu Phasenverschiebungen am Ausgang führen. Es kann daher vorteilhaft sein, auf diese Charakteristika Rücksicht zu nehmen und die für den jeweiligen Anwendungsfall günstigste Schaltung zu wählen. Ferner scheint es gerade bei der Verwendung einer entsprechenden Schaltung zweckmäßig, sie mit einer Abgleichschaltung zur Normierung der Signalformen der Eingangssignale und der Phasenabstände dieser Eingangssignale zu kombinieren.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen
- Fig. 1: in stark schematisierter Darstellungsweise ein erfindungsgemäßes inkrementales Meßsystem,
- Fig. 2: eine Variante der Abtasteinheiten für die Referenzspur bei dem Meßsystem nach Fig. 1,
- Fig. 3: einen integrierten Schaltkreis, wie er beim Erfindungsgegenstand Verwendung findet,
- Fig. 4: ein Diagramm zur Erläuterung der im Schaltkreis nach Fig. 3 auftretenden Signale und ihrer Auswertung,
- Fig. 5: eine weitere Variante der Signalauswertung bei einer Abtasteinheit für die Referenzspur,
- Fig. 6: ein Blockschaltschema einer bei der Schaltung nach Fig. 5 verwendbaren Frequenzverdoppelungsschaltung,
- Fig. 7: ein Blockschaltschema einer weiteren Frequenzverdoppelungsschaltung und
- Fig. 8: eine dritte Frequenzverdoppelungsschaltung.

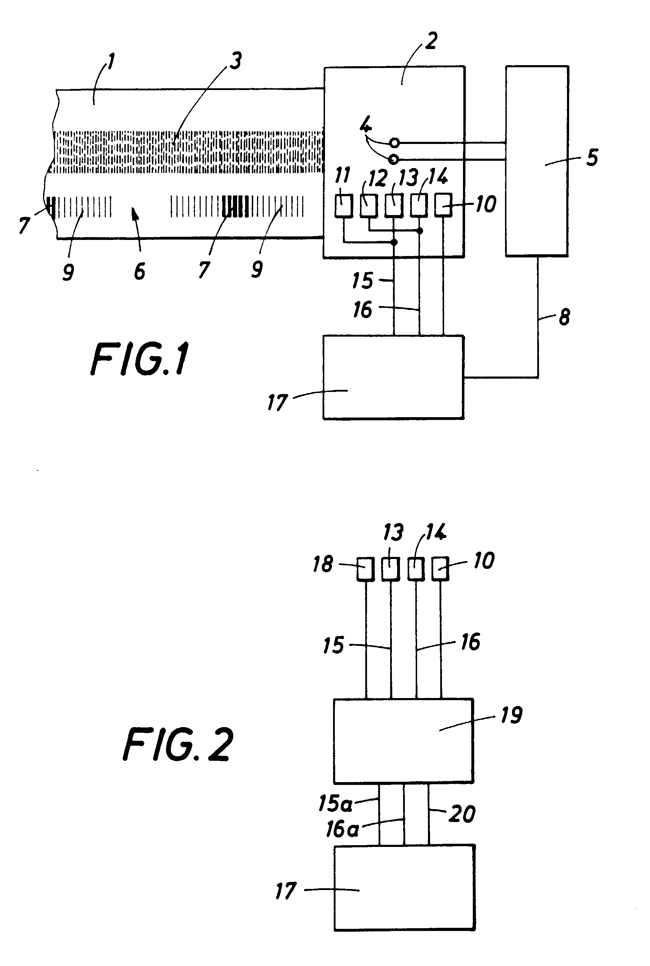

Nach Fig. 1 besitzt ein Meßsystem einen Maßstabkörper 1, der als Linearmaßstab dargestellt wurde, aber auch ein gekrümmter oder kreisförmiger Trägerkörper sein kann und zu dem ein Abtastkopf 2 relativ verschiebbar ist. Der Maßstabkörper 1 trägt eine hochauflösende Meßteilung 3 für die am Abtastkopf Abtasteinheiten 4 vorhanden sind, deren Ausgangssignale einer Auswertungseinheit 5 zugeführt werden, die sie zu digitalen Zähl- und Steuersignalen verarbeitet, wie dies bei Meßsystemen an sich bekannt ist, so daß sich hier eine weitere Beschreibung erübrigt.

In einer eigenen Referenzspur 6 des Maßstabkörpers sind eine oder mehrere Referenzmarken 7 angeordnet, durch deren Abtastung Referenzimpulse erzeugt werden sollen, die nur an einem bestimmten Punkt der Meßteilung 3 auftreten und die über eine Eingangsleitung 8 der Auswertungseinheit zugeführt werden. Um den Maßstabpunkt, an dem das Referenzsignal auftritt, genau zu definieren und um ferner die Impulsbreite des über 8 zugeführten Referenzimpulses möglichst klein zu halten, ist die beschriebene, besondere Ausführung vorgesehen. Dabei sind die Referenzmarken 7, wie ersichtlich, in den Referenzmarken zugeordnete Teilstücke 9 einer in der Referenzspur 6 angebrachten Inkrementalteilung integriert.

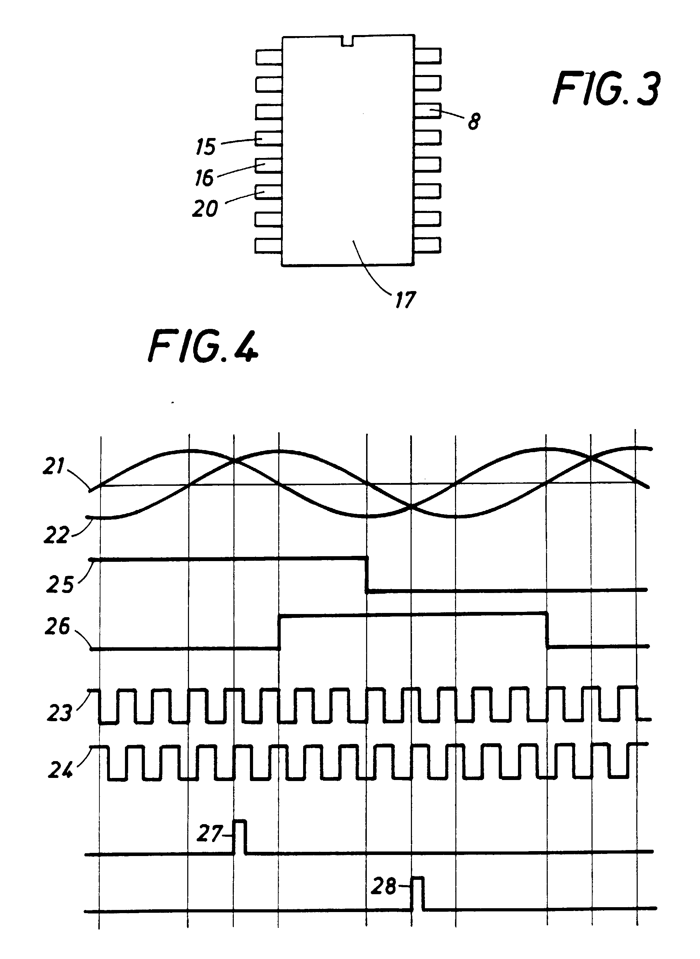

Nach Fig. 1 bestehen Abtasteinheiten für die Referenzspur 6, die diese beim Ausführungsbeispiel nach optoelektronischen Prinzipien abtasten, aus wenigstens einem Photoempfänger 10 zur Abtastung der Referenzmarken 7, der einem Abtastgitter mit dem Referenzmarkenmuster angepaßten Muster zugeordnet ist, so daß in einer bestimmten Relativstellung des Abtastgitters zu einer Referenzmarke eine deutlich erkennbare Änderung des an 10 erzeugten Signales auftritt. Die Signalbreite dieses Signales reicht aber über mehr als eine Teilungsstufe der Meßteilung 3. Um für den Referenzimpuls einen exakten Auslöspunkt und eine geringe Impulsbreite kleiner als die Teilungsstufe der Meßteilung 3 zu erreichen, ist die inkrementale Hilfsteilung 9 vorgesehen, für die nach Fig. 1 vier Photoempfänger 11, 12, 13, 14 am Abtastkopf 2 angebracht sind, wobei diesen Photoempfängern Abtastgitter für die Hilfsteilung 9 zugeordnet sind, die gegeneinander um Teilungsbruchteile versetzt sind, so daß die an den Empfängern 11 bis 14 empfangenen Signale gegeneinander im Idealfall um jeweils 90° phasenverschoben sind. Die um 180° phasenverschobene Signale erzeugenden Photoempfänger 11, 13 und 12, 14 werden paarweise in Gegenschaltung verbunden, so daß an Leitungen 15, 16 zwei um 90° gegeneinander phasenverschobene in der Grundform sinusförmige analoge Hilfssignale anstehen, die, ebenso wie das von der Abtasteinheit 10 erhaltene Referenzsignal einer Auswertungseinheit 17 zugeführt werden. In dieser Auswertungseinheit werden die analogen Hilfssignale über eine Unterteilungsschaltung im Sinne einer elektronischen Unterteilung der Hilfsteilung 9 geführt und es werden aus ihnen digitale Rechtecksignale erzeugt, wie dies noch im Zusammenhang mit Fig. 3 und 4 näher beschrieben wird. Durch Auswahlglieder wird bei an 17 anstehendem Referenzsignal ein Referenzimpuls erst bei einer vorbestimmten Phasenlage der Signale auf den Leitungen 15, 16 ausgelöst und bereits durch die Flanke des nächsten Rechtecksignales beim Weiterverstellung des Abtastkopfes 2 beendet, so daß auf der Leitung 8 nur Referenzimpulse mit geringer Impulsbreite und genauer Zuordnung zu einer Maßstabstelle auftreten können. Selbstverständlich sind auch bei der erfindungsgemäßen Ausführung Auswahlschaltungen möglich, die nach Speicherwerten oder Codierungen nur bestimmte Referenzmarken für die Erzeugung von Referenzimpulsen auswählen, wobei sogar die Hilfsteilungen 9 Teile entsprechender Codier- und Auswahleinrichtungen sein können.

Bei der Ausführung nach Fig. 2 sind nur zwei Abtasteinheiten für die Hilfsinkrementalteilung 9 vorgesehen, die gegeneinander um 90° phasenverschobene analoge Signale (sin- u. cos-Signal) erzeugen. Es ist aber eine weitere Abtasteinheit 18 für die Referenzmarken 7 zur Erzeugung eines Hilfssignales über einer Referenzmarke vorhanden und sowohl das Referenzsignal als auch das Referenzhilfssignal werden über eine Abgleicherschaltung 19 geführt, in der die Signalformen der Signale und die Phasenabstände des sin- und cos-Signales normiert werden, wobei an den Ausgangsleitungen 15a, 16a das normierte sin- bzw. cos-Signal und an einer weiteren Ausgangsleitung 20 das in Phasenlage und Abstand gegenüber dem normierten sin- und cos-Signal korrigierte bzw. normierte Referenzsignal auftritt und der Auswertungsschaltung 17 zugeführt wird. Die weitere Verarbeitung erfolgt entsprechend der zu Fig. 1 gegebenen Beschreibung.

In Fig. 3 ist die Auswertungsstufe 17 als integrierter Baustein veranschaulicht, der sowohl Unterteilungsstufen für die analogen Hilfssignale als auch Eingänge für das Referenzsignal besitzt und wenigstens einen Ausgang zur Abgabe des Referenzimpulses auf die Leitung 8 aufweist. Der Einfachheit halber wurden nur die sich aus den vorherigen Figuren ergebenden Leitungsverbindungen bzw. Anschlüsse für diese tungsverbindungen mit den gleichen Bezugszeichen bezeichnet. In Fig. 4 ist die Funktionsweise des Schaltkreises nach Fig. 3 erläutert. Der Schaltkreis erhält über die Leitungen 15, 16 ein analoges Sinussignal 21 und ebenfalls ein analoges Cosinussignal 22. Aus diesen beiden Signalen werden in der Unterteilerschaltung die gegeneinander um einen halben Schritt versetzten Taktsignale 23, 24 gebildet, die praktisch eine elektronische Unterteilung der Meßsignale aus der Abtastung der Hilfsteilung auf das Zehnfache darstellen. Je nach Auswertungsart kann das Referenzsignal in Form der Kurve 15 bzw. 26 auftreten. Eine Triggerschaltung überwacht die Signale 21 und 22 und ist so ausgelegt, daß dann, wenn ein Referenzsignal an 25 ansteht, bei gleicher Pegelhöhe der Signale 21, 22 durch die Flanke des Signales 24 ein Referenzimpuls 27 ausgelöst wird, der bei der entsprechend minimalen Weiterverstellung des Abtastkopfes 2 durch die Flanke des Signales 23 gelöscht wird, also eine der halben Breite der Rechteckimpulse 23 bzw. 24 entsprechende Breite aufweist. Wenn eine Ableitung des Referenzsignales nach der Kurve 26 vorgenommen wird, kann man am unteren Schnittpunkt der Spannungskurven 21, 22 in analoger Weise den Referenzimpuls 28 ableiten. Der Unterteilungsbaustein 17 nach Fig. 3 besitzt noch eine Reihe weiterer Funktionen, die aber für das Verständnis der Erfindung nicht nötig sind und daher nicht weiter erklärt werden.

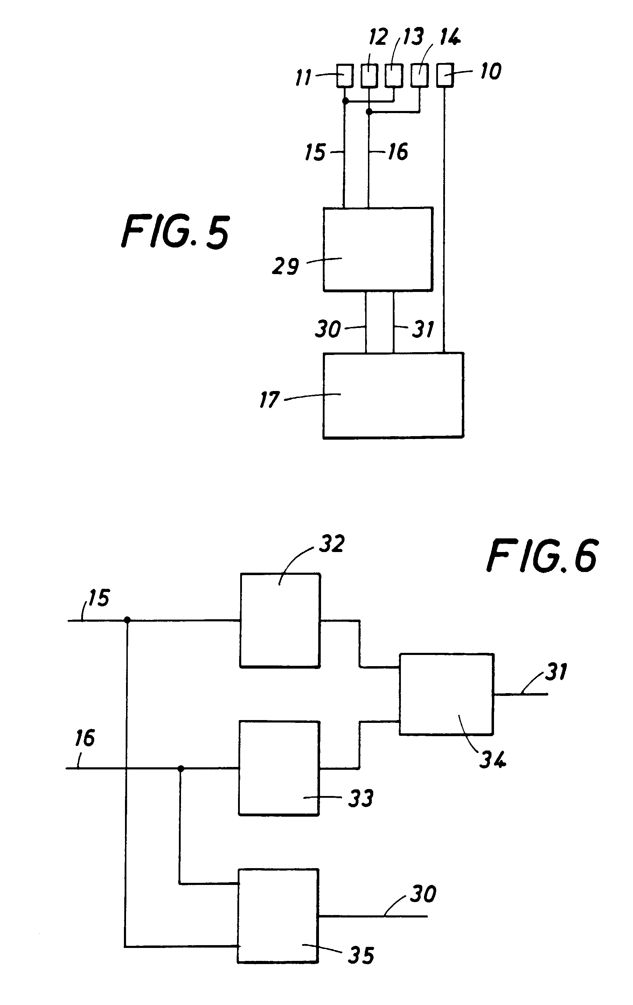

In Fig. 5 ist eine Schaltung gezeigt, die hinsichtlich der Abtastung der Referenzspur der Schaltung nach Fig. 1 entspricht. Die Signale auf den Leitungen 15, 16 werden aber über eine Frequenzvervielfachungs- bzw. verdoppelungsschaltung 29 geführt, so daß an deren Ausgang über die Leitungen 30 bzw. 31 Analogsignale abgegeben werden, welche gegenüber den Signalen auf den Leitungen 15, 16 die doppelte Frequenz aufweisen. Diese Signale werden der Auswertungseinheit 17 zur weiteren Verarbeitung in der beschriebenen Weise zugeleitet.

Beispiele für entsprechende Verdoppelungsschaltungen sind in den Fig. 6 bis 8 angegeben.

Nach Fig. 6 besitzt die Frequenzverdoppelungsschaltung je einen Vierquadrantenmultiplizierer 32, 33 für das ihm über die Leitung 15, 16 zugeführte sin- bzw. cos-Signal, wobei diese Multiplizierer so geschaltet sind, daß an ihrem Ausgang das Signal sin² x bzw. cos² x auftritt. Diese beiden Signale werden einem Subtrahierer 34 zugeführt, der aus cos² x - sin² x das Signal cos 2x bildet. Die Leitungen 15, 16 sind überdies mit einem weiteren Vierquadrantenmultiplizierer 35 verbunden, der diese beiden Signale durch Multiplikation verknüpft, so daß am Ausgang das Signal sin x * cos x entsprechend 0,5 sin 2x auftritt.

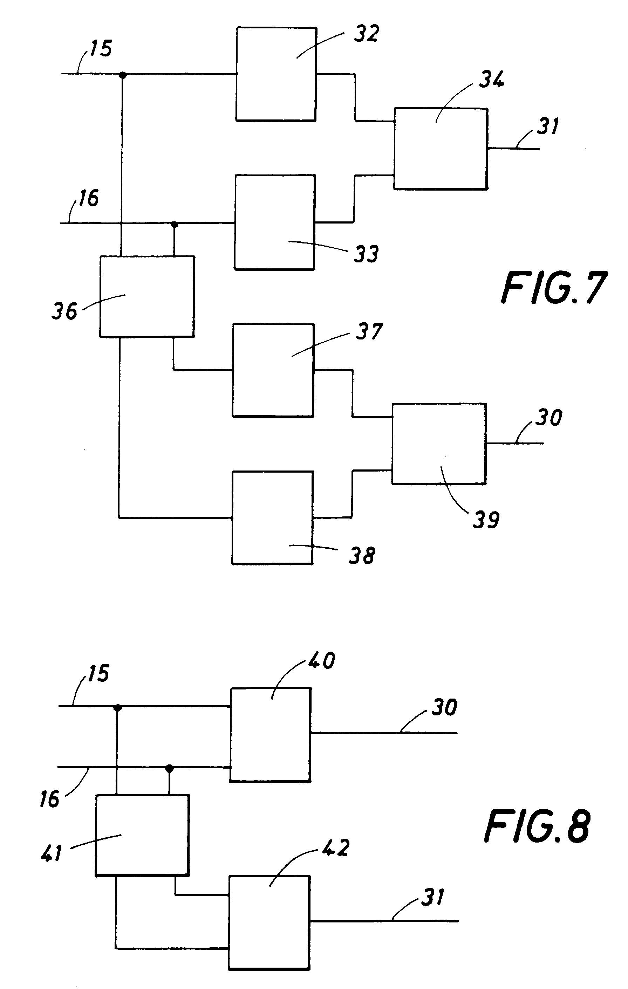

Bei der Schaltung nach Fig. 7 entspricht der obere Teil zur Bildung des Signales cos 2x auf der Leitung 31 der Schaltung nach Fig. 6. Zusätzlich werden von beiden Leitungen 15, 16 kommende Signale über π/4-Phasenschieber 36 geführt und getrennt zwei weiteren Vierquadrantenmultiplizierern 37, 38 zugeleitet, die aus ihnen Signale cos² x + 45 bzw. sin² x + 45 bilden, welche einem Subtrahierer 39 zugeleitet werden, an dessen Ausgangsleitung 30 somit das Signal sin 2x ansteht.

Nach Fig. 8 werden die Signale der Leitungen 15, 16 wieder einem Vierquadrantenmultiplizierer 40 zur Bildung des Signales sin x * cos x entsprechend 0,5 * sin 2x auf der Leitung 30 zugeführt und über einen weiteren Phasenschieber 41 einem weiteren Vierquadrantenmultiplizerer 42 zur Bildung des Signales 0,5 * cos 2x auf der Leitung 31 zugeleitet.

## Patentansprüche

1. Inkrementales Meßsystem mit einem eine Meßteilung (3) tragenden Maßstab (1) und in wenigstens einer eigenen Abtastspur (6) angeordneten Referenzmarken (7), wobei
- für die Meßteilung (3) und die Referenzmarkenspur (6) gesonderte Abtasteinheiten (4, 10 bis 14) zur Erzeugung von Meßsignalen und von der Abtastung der Meßteilung unabhängigen Referenzsignalen vorgesehen sind,
- phasenverschobene periodische Hilfssignale (21, 22) erzeugt werden, für die Erzeugungsschaltungen (17, 29) zur Erzeugung von dem Teilungsgrad der Meßteilung entsprechenden digitalen Ausgangssignalen (23, 24) vorgesehen sind, wobei diese Ausgangssignale bei an der entsprechenden Abtasteinheit (10) bei ihrer Ausrichtung auf eine Referenzmarke anstehendem Referenzsignal in einer vorwählbaren Phasenlage der Hilfssignale zur Auflösung und zur Begrenzung der Impulsbreite eines weitergeleiteten Referenzimpulses (27, 28) verwendet werden
- und das aus Meßteilung (3) und zugeordneten Abtasteinheiten (4) gebildete Meßsystem ein hohes Auflösungsvermögen aufweist,
**dadurch gekennzeichnet, daß**
die Referenzmarkenspur (6) zumindest im Bereich der Referenzmarken (7) ein- oder beidseitig mit einer eine geringere Auflösung als die Meßteilung (3) aufweisenden Inkrementalteilung (9), insbesondere einer ebenso wie die in diese Inkrementalteilung integrierten Referenzmarken nach optoelektronischen Abtastprinzipien abtastbaren Inkrementalteilung versehen ist, für die eigene Abtasteinheiten (11 bis 14) zur Erzeugung der phasenverschobenen periodischen Hilfssignale (21, 22) vorgesehen sind
und daß die Erzeugungsschaltungen (17, 29) Unterteilerschaltungen sind, die die Hilfs-lnkrementalteilung elektronisch unterteilen.

2. Inkrementales Meßsystem nach Anspruch 1, dadurch gekennzeichnet, daß, die Abtasteinheiten (11 bis 14) für die den Referenzmarken (7) zugeordnete Inkrementalteilung (9) zur Erzeugung von zwei gegeneinander um 90° phasenverschobenen, sinusförmigen Hilfssignalen (21, 22) um Teilungsbruchteile versetzte Abtastgitter aufweisen und daß für die Auslösung des Referenzimpulses eine bei anstehendem Referenzsignal auf gleiche Signalhöhen der beiden Hilfssignale (Schnittpunkte der beiden Spannungskurven) empfindliche Triggerschaltung (17) vorgesehen ist.

3. Inkrementales Meßsystem nach Anspruch 1 oder 2, dadurch gekennzeichnet, daß den Abtasteinheiten (10, 13, 14, 18) für die Hilfssignale und das Referenzsignal eine Abgleichschaltung (19) zur Normierung der Signalformen aller Signale und der Phasenabstände der Hilfssignale nachgeordnet ist.

4. Inkrementales Meßsystem nach einem der Ansprüche 1 bis 3, dadurch gekennzeichnet, daß für die phasenverschobenen analogen Hilfssignale eine Frequenzverdoppelungsschaltung (29) mit festen Rechnerbausteinen (32 bis 42) vorgesehen ist.

5. Inkrementales Meßsystem nach Anspruch 4, dadurch gekennzeichnet, daß die Frequenzverdoppelungsschaltung (29) je einen Vierquadrantenmultiplizierer (32) für das sin- und cos-Signal zur Bildung von sin²x und cos²x aufweist, deren Ausgänge mit einem Subtrahierer (34) verbunden sind, an dessen Ausgang das Signal cos 2x ansteht und ein weiterer drantenmultiplizierer (35) sowohl mit dem Signal sin x als auch dem cos x zur Bildung eines sin x * cos x = 0,5 sin 2x-Signales am Ausgang (30) beaufschlagbar ist.

6. Inkrementales Meßsystem nach Anspruch 4, dadurch gekennzeichnet, daß die Frequenzverdoppelungsschaltung (29) je einen Vierquadrantenmultiplizierer (32, 33) für das sin- und cos-Signal zur Bildung von sin²x und cos²x aufweist, deren Ausgänge mit einem Subtrahierer (34) verbunden sind, an dessen Ausgang das Signal cos 2x ansteht und zwei weitere quadrantenmultiplizierer (37, 38) über π/4-Phasenschieber mit den Signalen cos (x + 45) bzw. sin (x + 45) beaufschlagbar sind und die an ihren Ausgängen auftretenden Signale cos² (x + 45) bzw. sin² (x + 45) in einem Subtrahierer (39) zu dem Signal sin 2x verknüpft werden.

7. Inkrementales Meßsystem nach Anspruch 4, dadurch gekennzeichnet, daß die Frequenzverdoppelungsschaltung (29) einen mit dem sin x und cos x-Signal beaufschlagten drantenmultiplizierer zur Bildung von sin x * cos x = 0,5 * sin 2x und einen weiteren, über π/4 Phasenschieber (41) mit den Signalen cos (x + 45) und sin (x + 45) beaufschlagten Vierquadrantenmultiplizierer (42) zur Bildung von sin(x + π/4) * cos (x + π/4) = 0,5 * cos 2x aufweist.

## Claims

1. An incremental measuring system comprising a scale (1) bearing graduations (3) and reference marks (7) disposed in at least one separate scanning track (6), wherein
- separate scanning units (4, 10 - 14) for the graduations (3) and the reference-mark track (6) are provided for generating measuring signals and reference signals independent of the scanning of the graduations,
- phase-shifted periodic auxiliary signals (21, 22) are generated for the circuits (17, 29) for generating digital output signals (23, 24) corresponding to the particular graduation, the output signals being used to resolve and limit the width of a transmitted reference pulse (27, 28) when the auxiliary signals are in a preselected phase position and the reference signal appears at the corresponding scanning unit (10) when it is aligned with a reference mark, and
- the measuring system made up of the graduations (3) and associated scanning units (4) has a high resolving power,
characterised in that
the reference-mark track (6), at least in the region of the reference marks (7), is provided on one or both sides with incremental graduations (9) having less resolution than the measuring graduation (3), more particularly incremental graduations which, like the reference marks incorporated therein, can be scanned on opto-electronic principles, for the individual scanning units (11 - 14) for generating the phase-shifted periodic auxiliary signals (21, 22), and
in that the generating circuits (17, 29) are subdividing circuits which electronically subdivide the auxiliary incremental graduations.

2. An incremental measuring system according to claim 1, characterised in that the scanning units (11 to 14) have scanning gratings offset by fractions of a graduation for the incremental graduations (9) associated with the reference marks (7), for generating two sinusoidal auxiliary signals (21, 22) phase-shifted by 90°, and in that a trigger circuit (17) is provided for resolving the reference pulse and, on receipt of a reference signal, is sensitive to equal levels of the two auxiliary signals (the points of intersection of the two voltage curves).

3. An incremental measuring system according to claim 1 or 2, characterised in that the scanning units (10, 13, 14, 18) for the auxiliary signals and the reference signal are followed by a balancing circuit (19) for standardising the shapes of all the signals and the phase distances between the auxiliary signals.

4. An incremental measuring system according to any of claims 1 to 3, characterised in that a frequency doubling circuit (29) with fixed computer units (32 - 42) is provided for the phase-shifted analog auxiliary signals.

5. An incremental measuring system according to claim 4, characterised in that the frequency doubling circuit (29) has respective four-quadrant multipliers (32) for the sine and cosine signal for forming sin²x and cos²x, the multiplier outputs being connected to a subtractor (34) which outputs the signal cos 2x, and an additional four-quadrant multiplier (35) is adapted to be supplied with the signal sin x and also with cos x for forming a sin x * cos x = 0.5 sin 2x signal at the output (30).

6. An incremental measuring system according to claim 4, characterised in that the frequency doubling circuit (29) comprises respective four-quadrant multipliers (32, 33) for the sine and cosine signal for forming sin² x and cos² x, the multiplier outputs being connected to a subtractor (34) which outputs the signal cos 2x, and two additional four-quadrant multipliers (37, 38) are adapted to be supplied, via π/4 phase shifters, with the signals cos (x + 45) and sin (x + 45) respectively and the signals cos² (x + 45) and sin² (x + 45) appearing at their outputs are linked in a subtractor (39) to form the signal sin 2x.

7. An incremental measuring system according to claim 4, characterised in that the frequency doubling circuit (29) comprises a four-quadrant multiplier supplied with the sin x and cos x signal for forming sin x * cos x = 0.5 sin 2x and an additional four-quadrant multiplier supplied with the signals cos (x + 45) and sin (x + 45) via π/4 phase shifters (41) for forming sin (x + π/4) * cos (x + π/4) = 0.5 * cos 2x.

## Revendications

1. Système de mesure incrémentiel, comportant une règle graduée (1) et des marques de référence (7) disposées dans au moins une piste d'exploration (6) propre, où
- des unités d'exploration (4, 10 à 14) séparées sont prévues pour la division de mesure (3) et la piste à marques de préférence (6), afin de générer des signaux de mesure et des signaux de référence, indépendants de l'exploration de la division de mesure,
- des signaux auxiliaires (21, 22) périodiques déphasés sont générés pour les circuits de génération (17, 29) destinés à générer des signaux de sortie (23, 24) numériques correspondants au degré de division de la division de mesure, ces signaux de sortie, lorsqu'un signal de référence apparaît sur l'unité d'exploration (10) correspondante lors de son orientation sur une marque de référence, étant utilisés en une position de face présélectionnable des signaux auxiliaires pour obtenir une résolution et pour délimiter la largeur d'impulsion de référence (27, 28) ayant été transmise,
- et le système de mesure constitué de la division de mesure (3) et des unités d'exploration (4) associés présentant une capacité de résolution élevée,
caractérisé en ce que
la piste à marques de référence (6) est pourvue, au moins dans la zone des marques de référence (7), sur un ou deux côtés, d'une division incrémentielle (9) présentant une moindre résolution que la division de mesure (3), en particulier une division incrémentielle pouvant être explorée selon les principes d'exploration optoélectronique tout comme les marques de référence intégrées dans cette division incrémentielle, division incrémentielle pour laquelle sont prévues des unités d'exploration (11 à 14) propres destinés à générer les signaux auxiliaires (21, 22) périodiques déphasés,
et en ce que les circuits de génération (17, 19) sont des circuits de subdivision, produisant une subdivision électronique de la division incrémentielle auxiliaire.

2. Système de mesure incrémentiel selon la revendication 1, caractérisé en ce que les unités d'exploration (11 à 14) destinées à la division incrémentielle (9) associée aux marques de référence (7) présentent, pour la génération de deux signaux auxiliaires (21, 22) de forme sinusoïdale déphasés de 90° l'un par rapport à l'autre, une grille d'exploration décalée de la valeur de fractions de la division et en ce que pour la résolution de l'impulsion de référence est prévu un circuit de déclenchement (17) qui est sensible, lors de l'application d'un signal de référence, à l'égalité des valeurs des deux signaux auxiliaires (point d'intersection entre les deux courbes de tension).

3. Système de mesure incrémentiel selon la revendication 1 ou 2, caractérisé en ce qu'un circuit d'équilibrage (19), destiné à normer les formes de tous les signaux et les espacements entre phases des signaux auxiliaires, est monté en circuit en aval des unités exploration (10, 13, 14, 18) destinées aux signaux auxiliaires et au signal de référence.

4. Système de mesure incrémentiel selon l'une des revendications 1 à 3, caractérisé en ce qu'un circuit de doublage de fréquence (29), doté de composants calculateurs (32 à 42) fixes, est prévu pour les signaux auxiliaires analogiques déphasés.

5. Système de mesure incrémentiel selon la revendication 4, caractérisé en ce que le circuit de doublage de fréquence (29) présente respectivement un multiplicateur à quatre quadrants (32) pour le signal sinusoïdal et le signal cosinusoïdal, afin de former les valeurs de sin²x et cos²x, dont les sorties sont reliées à un soustracteur (34) à la sortie duquel est produit le signal cos 2x, et un autre multiplicateur à quatre quadrants (35) étant alimenté tant avec le signal sin x qu'également avec le signal cos x pour former un signal de valeur sin x * cos x = 0,5 sin 2x à la sortie (30).

6. Système de mesure incrémentiel selon la revendication 4, caractérisé en ce que le circuit doubleur de fréquence (29) présente respectivement un multiplicateur à quatre quadrants (32, 33) pour le signal sinusoïdal et le signal cosinusoïdal, afin de former les valeurs sin²x et cos²x, dont les sorties sont reliées à un soustracteur (34) à la sortie duquel est produit le signal cos 2x et deux autres multiplicateurs à quatre quadrants (37, 38) étant susceptibles d'être alimentés, par l'intermédiaire de déphaseurs π/4, avec les signaux cos (x + 45), respectivement sin (x + 45) et les signaux, apparaissant à leurs sorties et de valeur cos² (x + 45), respectivement sin² (x + 45), étant combinés dans un soustracteur (39) avec le signal sin 2x.

7. Système de mesure incrémentiel selon la revendication 4, caractérisé en ce que le circuit de doublage de fréquence (29) présente un multiplicateur à quatre quadrants alimenté par le signal sin x et le signal cos x pour former des signaux de valeur sin x * cos x = 0,5 * sin 2x et présente un autre multiplicateur à quatre quadrants (42), pouvant être alimenté, par l'intermédiaire d'un déphaseur π/4 (41), avec les signaux cos (x + 45) et sin (x + 45), pour former les valeurs sin (x + n/4) * cos (x + π/4) = 0,5 * cos 2x.
